# EUROPÄISCHE PATENTSCHRIFT

(11) **EP 0 494 340 B1**
(45) Veröffentlichungstag und Bekanntmachung des Hinweises auf die Patenterteilung: **15.03.1995**
(21) Anmeldenummer: 91114756.9
(22) Anmeldetag: 02.09.1991
(51) Int. Cl.: C23C 14/04, H01G 13/06, C23C 14/56

(54) **Vorrichtung zum Herstellen von metallfreien Streifen**
Apparatus for obtaining metal-free stripes
Dispositif pour l'obtention de raies exemptes de métal

(30) Priorität: 11.01.1991 DE 4100643
(43) Veröffentlichungstag der Anmeldung: 15.07.1992
(73) Patentinhaber: LEYBOLD AKTIENGESELLSCHAFT, D-63450 Hanau (DE)
(72) Erfinder: Kleyer, Siegfried, W-6452 Hainburg (DE)
(74) Vertreter: Sartorius, Peter, Dipl.-Ing.

(56) Entgegenhaltungen:
- EP-A- 0 447 550
- WO-A-90/06586
- CH-A- 295 688
- US-A- 4 832 983

## Beschreibung

Die Erfindung bezieht sich auf eine Vorrichtung zum Herstellen von metallfreien Streifen auf im Vakuum beschichteten Folienbahnen mit einem druckdicht verschließbaren Gehäuse, in dem eine Einrichtung zur Aufnahme und Weiterbewegung einer Folienbahn, insbesondere für Kondensatoren, vorgesehen ist, sowie einer im Gehäuse vorgesehenen Verdampfungsquelle und einer Düse für den Austritt des zu verdampfenden Mittels zur Verhinderung von Kondensation auf die vorbeilaufende Folienbahn.

Weiterhin ist eine Vorrichtung zum gleichzeitigen Aufdampfen von mehreren parallelen Streifen aus flüssigen oder fettartigen Stoffen mit niedrigem Dampfdruck, vorzugsweise öligen Substanzen, insbesondere auf bestimmten Bändern, als Abdeckmittel für eine nachfolgende Metallbedampfung bekannt (DE-PS 1 262 732). Diese Vorrichtung besteht aus einem mit einer Heizwicklung umwickelten Verdampfergefäß, das mehrere von einem Vorratsgefäß gespeiste Verdampferdüsen aufweist. Das rohrförmige Verdampfergefäß weist eine dem Abstand und der Breite der herzustellenden Abdeckstreifen entsprechend angeordnete Anzahl von Düsen auf, über die das Mittel auf die Oberfläche der Folie gelangt.

Es ist ferner allgemein bekannt, daß Wickelkondensatoren fast ausschließlich aus metallisierten Kunststofffolien oder metallisierten Papieren hergestellt werden. Das hat gegenüber den aus Aluminiumfolie hergestellten Kondensatoren den Vorteil, daß sie sich bei geringfügigen Beschädigungen selbst heilen. Kurzschlüsse zwischen den beiden Metallbelägen werden ausgebrannt, da beim einmaligen Kurzschluß ein isolierender Metallbereich gebildet wird. Mit zunehmender Kapazität eines Kondensators kann die im Kurzschluß freiwerdende Entladungsenergie zu groß werden, so daß benachbarte Wickellagen beschädigt werden. Eine derartige Schädigung pflanzt sich wie eine Kettenreaktion bis in die inneren oder äußeren Lagen fort. Im Extremfall kann der Kondensator aufgrund derartiger Beschädigungen explodieren und in Brand geraten.

Außerdem ist es bekannt (CH-A-295 688), eine Vorrichtung der eingangs aufgeführten Art zum Herstellen von metallfreien Streifen auf im Vakuum beschichteten Folienbahnen einzusetzen, wobei die Folienbahnen durch Benutzung einer Walze mit Aussparungen gekennzeichnet sind. In Verbindung mit dieser Walze und diesen Aussparungen wird jedoch keine Düse benutzt.

Der vorliegenden Erfindung liegt die Aufgabe zugrunde, Mittel derart aufzubringen, daß der Kurzschluß reduziert und nur auf einem ganz bestimmten Teil der Kondensatorfolie wirksam wird.

Erfindungsgemäß wird diese Aufgabe dadurch gelöst, daß vor dem Auslaß der Düse mindestens eine eine Nut aufweisende Walze vorbei bewegbar ist und die Düse aus mindestens einer sich in etwa über die gesamte Breite der Folienbahn erstreckenden Öffnung gebildet ist. Hierdurch lassen sich auf einfache Weise auf der Oberfläche der Folienbahn Quer- und Längsstreifen aufbringen, wenn die Folienbahn unterhalb der Düse vorbei bewegt wird, je nachdem, mit welcher Geschwindigkeit die Folienbahn an der Düse vorbei bewegt wird.

Vorteilhaft ist es dazu, daß sich die Nut in etwa über die gesamte Breite der Walze erstreckt, wobei die Nut unterbrochen sein kann, und daß die Nut mit Bezug auf die Querebene der Walze in einem Winkel zwischen 0° und 90° auf der Oberfläche der Walze angeordnet ist. Hierdurch läßt sich die Folienbahn mit einem Minimum an Aufwand in einzelne Segmente unterteilen, die durch die Querstreifen begrenzt werden. Mit den einzelnen Quer- und Längsstreifen erhält man unmetallisierte Flächen und dadurch die Möglichkeit, die Kurzschlußamplitude zu verringern, da die Querstreifen das eine Segment gegenüber dem benachbarten Segment isolieren. Durch die Segmentierung werden auf einfache Weise die Eigeninduktivität und der Innenwiderstand des Kurzschlußkreises erhöht, da auf vorteilhafte Weise die metallisierte Oberfläche durch nicht metallisierte Querstreifen unterbrochen ist.

Hierzu ist es ferner vorteilhaft, daß die einzelnen Streifen durch einen aufbringbaren Ölfilm erzeugt werden, so daß sich an dieser Oberfläche der Folie kein Metalldampf niederschlagen kann.

In weiterer Ausgestaltung der Erfindung ist es vorteilhaft, daß die Düse zahlreiche nebeneinander angeordnete Auslaßöffnungen aufweist und parallel zur Längsachse der Walze verläuft, wobei die Düse in einer Blende bzw. Gleitdichtung angeordnet ist. Hierdurch kann der Verschleiß im Bereich der Austrittsöffnung bzw. an Dichtstellen gering gehalten werden, da die Folienbahn ohne weiteres an diesen Öffnungen vorbei bewegt werden kann, selbst dann, wenn die Kanten der einzelnen Öffnungen nicht aufspringen bzw. radial vorstehen.

Ferner ist es vorteilhaft, daß die Düse aus einer Schlitzöffnung gebildet ist, die sich in etwa über die gesamte Breite der Folienbahn erstreckt. Wird nun unter der Düse mit der Schlitzöffnung in senkrechter Richtung dazu eine Fläche bzw. die Walze mit der ansteigenden Nut bewegt, dann wandert der sichtbare Teil innerhalb des Schlitzes von der einen Seite auf die andere, so daß je nach Geschwindigkeit der Walze quer verlaufende, geneigt verlaufende oder längs verlaufende, nicht metallisierende Streifen gebildet werden.

Von besonderer Bedeutung ist bei der erfindungsgemäßen Vorrichtung, daß die Düse Teil einer Gleitdichtung ist, die gegen die rotierende Walze dichtend anliegt und an der die Folienbahn dichtend vorbei bewegt wird.

In weiterer Ausgestaltung der Erfindung ist es vorteilhaft, daß in den längs verlaufenden Streifen mit Abstand zueinander verlaufende Öffnungen vorgesehen sind, wobei jeweils zwischen zwei quer verlaufenden Streifen mindestens eine Öffnung vorgesehen ist. Durch die Verwendung bzw. Aufdampfung eines unterbrochenen unmetallisierten Längsstreifens im Randbereich der Folie wird erreicht, daß nur ein schmaler Streifen übrig bleibt, über den der Strom fließen kann, und zwar über die im Längsstreifen vorgesehene Unterbrechung. Diese Unterbrechung hat die Funktion einer Sicherung, d. h. der Strom, der über diese Unterbrechung fließt, bewirkt nur an dem schmalen Streifen ein Durchbrennen, bevor eine Schädigung der Nachbarfolien eintritt.

Vorteilhaft ist es außerdem, daß auf der Walze eine oder mehrere sich radial erstreckende Nuten vorgesehen sind, die eine oder mehrere Unterbrechungen aufweisen, und daß die Walze in Folienlängsrichtung und synchron zur Geschwindigkeit der Folienbahn bewegbar ist.

Vorteilhaft ist es ferner, daß die Gleitdichtung in einer gebogenen Bahn gegen die Walze zur Anlage bringbar ist und mittels einer Spannvorrichtung gespannt werden kann und daß die Folienbahn gleitend an der Düse anliegt oder mit Abstand zu dieser angeordnet ist.

Außerdem ist es vorteilhaft, daß auf der Oberfläche der Folienbahn mittels der rotierenden Walze und der Düse quer ansteigende und/oder in Längsrichtung der Folienbahn nicht metallisierende Streifen aufdampfbar sind.

Weitere Merkmale der Erfindung sind in der Beschreibung der Figuren dargestellt, wobei bemerkt wird, daß alle Einzelmerkmale und alle Kombinationen von Einzelmerkmalen erfindungswesentlich sind.

In den Figuren ist die Erfindung an einer Ausführungsform beispielsweise dargestellt, ohne auf diese Ausführungsform beschränkt zu sein. Es zeigt:
- Fig. 1: eine Seitenansicht einer Bandbeschichtungsanlage mit einer Wickelvorrichtung und zahlreichen Umlenkrollen für die Folienbahn im Schnitt,
- Fig. 2: eine Abwicklung der eine Nut aufweisenden Walze mit der zugehörigen, einen Querschlitz aufweisenden Blende,
- Fig. 3: einen Schnitt einer Dichtlippe,
- Fig. 4: einen Schnitt eines Dichtteils,
- Fig. 5: eine Draufsicht der Düsenleiste mit zahlreichen Öffnungen,
- Fig. 6: eine Schnittdarstellung einer Verdampferkammer mit einer Gleitdichtung,
- Fig. 7: eine Schnittdarstellung der Umlenkwalze gemäß Figur 1 mit vor der Austrittsöffnung des Verdampfers vorgesehener Kondensatorfolie,
- Fig. 8: die Fläche einer Folienbahn.

In der Zeichnung ist mit 1 eine Bandbeschichtungsanlage bezeichnet, die im wesentlichen aus den zwischen zwei Seitenteilen 2, 4 gelagerten Umlenk-, Streck- und Spannrollen 7 bis 13 bzw. der gekühlten Beschichtungswalze 18 besteht. Ferner weist die Bandbeschichtungsanlage 1 eine Abwickelrolle 37, eine Aufwickelrolle 35, eine Beschichtungskammer 28 und eine Verdampfungsquelle 19 mit einer Aluminiumdrahtspule 20 und dem Verdampfungsschiffchen 21 auf. Die Wickeleinrichtung 29 ist an der oberen Kammerhälfte vorgesehen.

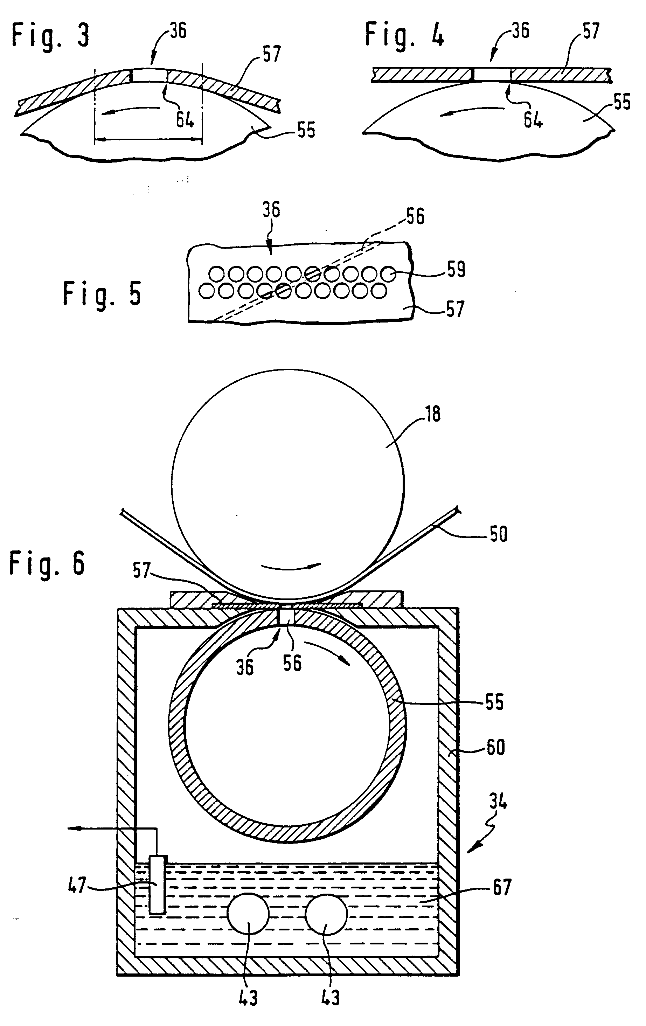

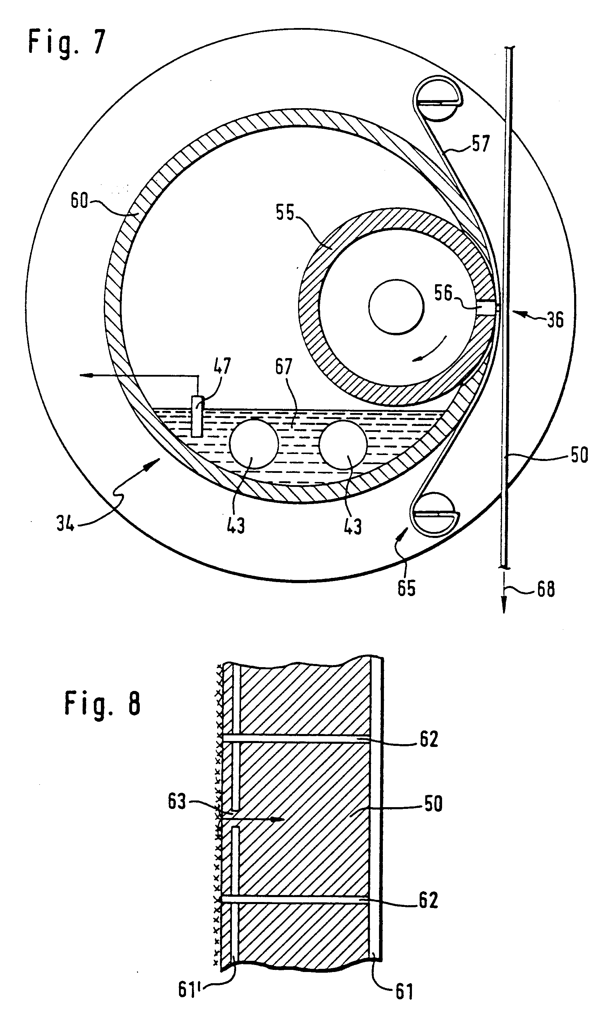

Ein in Figur 6 bzw. 7 dargestellter Ölverdampfer 34 besteht aus einem rohrförmigen bzw. rechteckigen Gehäuse 60, in dem ein oder mehrere stabförmige Heizelemente 43 angeordnet sind, die vom Mittel bzw. Öl 67 zur Verhinderung von Kondensation vollständig von Öl umspült sind und die sich im Bereich eines in der Zeichnung nicht dargestellten Dampfaustrittsrohrs befinden können. In vorteilhafter Weise kann der Ölverdampfer 34 mit einem Temperaturfühler 47 ausgestattet sein, der eine genaue Überwachung und Einhaltung der Mittelbadtemperatur gestattet. Der für die Überwachung der Regelung des Heizkreises notwendige elektrische Schaltkreis ist in der Zeichnung nicht dargestellt.

Der Ölverdampfer 34 ist mit Hilfe von in der Zeichnung nicht dargestellten Winkelstücken zwischen den beiden Seitenteilen 2, 4 gehalten, und zwar so, daß die Strahlrichtung einer Düse 36 des Ölverdampfers 34 gegen die zu beschichtende Seite des Bandes bzw. der Folienbahn 50 ausgerichtet ist. Eine ähnliche Anordnung des Ölverdampfers 34 ist in Figur 7 dargestellt.

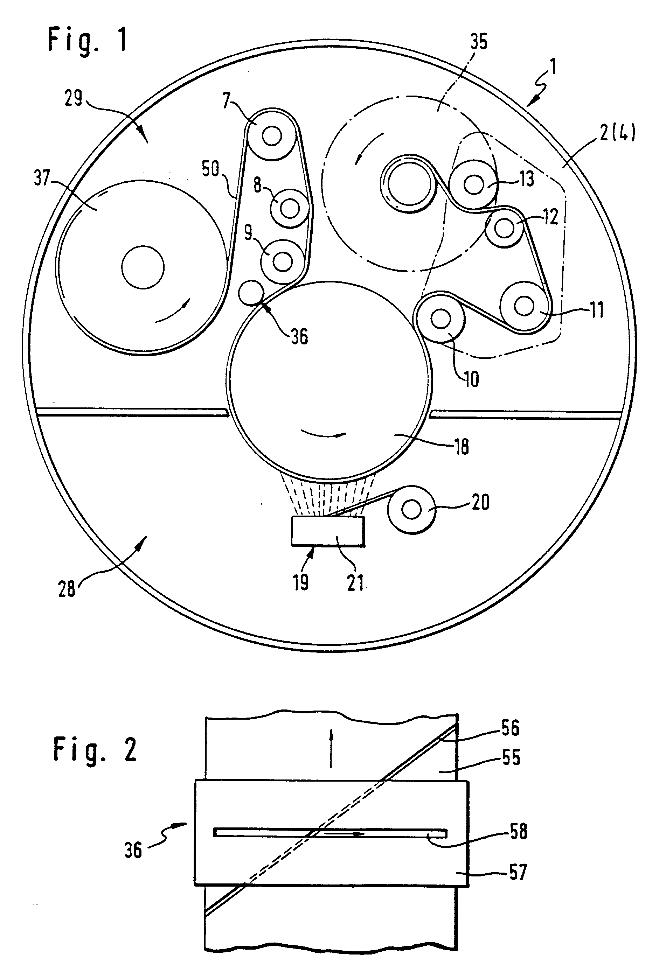

Wie Figur 1 zeigt, ist die Düse 36 an einem Abschnitt zwischen sich, einer Umlenkrolle 9 und der Beschichtungswalze 18 angeordnet, so daß unmittelbar nach dem Benetzen der durchlaufenden Folienbahn 50 mit dem Mittel 67 der eigentliche Beschichtungsprozeß erfolgt. Es ist vorteilhaft, daß sich auf den Partien der Folienbahn 50, die vom Mittel 67, beispielsweise einem Silikonöl, benetzt worden sind, das im Verdampfungsschiffchen 21 verdampfte Metall nicht niederschlagen kann.

Es hängt von der Art der Düsen 36 ab, wieviele Partien der Seitenfläche der Folienbahn 50 unbedampft bzw. unbeschichtet bleiben.

Bei der in der Figur 1 dargestellten Vorrichtung sind die Walzen 7 bis 13 zum Transport und zur Führung der Folienbahn 50 so angeordnet, daß die Partie der Folienbahn 50, die sich unmittelbar vor der Beschichtungswalze 18 befindet, in einem steilen Winkel, d. h. nahezu lotrecht von der Walze 9 aus nach unten läuft. Es ist auch möglich, daß diese Partie der Folienbahn 50 anders geführt werden kann, beispielsweise kann sie in einer etwa horizontalen Ebene gemäß Figur 6 auf der Beschichtungswalze 18 auflaufen, ohne daß der in Figur 6 näher dargestellte Ölverdampfer 34 in seiner Konstruktion geändert werden muß.

Wie aus Figur 6 und Figur 7 hervorgeht, ist in dem Gehäuse des Ölverdampfers 34 eine zylindrische Walze 55 drehbar gelagert, auf deren Oberfläche eine Nut 56 vorgesehen ist. Die Nut 56 kann auf einem Winkel zwischen 0° und 90° verlaufen. Die Nut 56 dient der Aufnahme eines Ölfilms, so daß Öldampf über die Düse 36 in das Vakuum auf die Oberfläche der Folienbahn 50 abgegeben werden kann. Die Folienbahn 50 wird mittels der Beschichtungswalze 18 an dieser Walze 55 vorbeigeführt.

Die Nut 56 kann über kleine Öffnungen mit dem Innenraum der Walze 55 verbunden sein, der mit Öldampf gefüllt sein kann, um eine ausreichende Dampfmenge auf die vorgeführte Folie übertragen zu können.

Die in Figur 1, 2 nur schematisch dargestellte Düse 36 befindet sich gemäß Figur 2, 5 und 6 in einer Gleitdichtung 57 und wird durch einen quer verlaufenden Schlitz 58 oder durch zahlreiche nebeneinander angeordnete Bohrungen 59 gemäß Figur 5 gebildet.

In Figur 8 stellt die schraffierte Fläche die Folienbahn 50 dar, auf der vertikal verlaufende Streifen 61, 61' und horizontal verlaufende Streifen 62 aufgedampft sind. Diese Streifen 61, 62 werden mittels der Düse 36 und des Ölverdampfers 34 auf die Oberfläche der Folienbahn 50 aufgebracht bzw. aufgedampft. Hierzu befindet sich in dem Gehäuse 60 ein Ölbad 67, das mittels einer in der Zeichnung nicht dargestellten Heizung aufgeheizt wird. Das Öl wird auf die gewünschte Temperatur aufgeheizt, so daß das Öl verdampfen kann, wenn der Arbeitsdruck erreicht und die Düsenöffnung freigegeben worden ist. Das Öl 67 entweicht dann stets an der Nut 56 in der Walze 55, da nur ein Segment freigegeben wird. Der auf der Oberfläche der Folienbahn 50 aufgedampfte Ölfilm hängt, wie bereits erwähnt, von der Umfangsgeschwindigkeit der Walze 55 und der Bewegung der Folienbahn 50 ab.

Die Streifen 61, 62 müssen weder unbedingt senkrecht noch waagerecht verlaufen. Der Abstand der quer verlaufenden Streifen 61, 62 kann zum Beispiel zwischen 60 und 80 mm je nach Anlage oder Ausbildung der Folienbahn 50 betragen.

Durch das Aufdampfen des Mittels 67 in Form von Querstreifen wird verhindert, daß sich an dieser Stelle Metall niederschlägt.

Wird gemäß Figur 2 oder 5 unter Verwendung des feststehenden Schlitzes 58 oder der dicht nebeneinander angeordneten Bohrungen 59 in etwa senkrechter Richtung dazu die Walze 55 bewegt (Figur 2 zeigt die Abwicklung der Walze 55 gemäß Figur 6 und 7), auf welcher sich eine Nut 56 unter einem Winkel zwischen 0° und 90° bewegt, dann wandert der sichtbare Teil innerhalb des Schlitzes 58 von einer Seite zur anderen.

Der Ölverdampfer 34 weist in seinem Gehäuse 60 die rotierende Walze 55 mit den Nuten 56 auf. Die Nuten 56 können sich entweder radial mit einer Steigung über die gesamte Breite der Folienbahn 50 erstrecken oder auch radial mit Unterbrechungen versehen sein.

Die gleitende bzw. eine Gleitfläche aufweisende, feststehende Dichtung 57 gibt mit ihrem Schlitz 58 oder den Öffnungen 59 Segmente der Nuten 56 frei. Bei Rotation der Walze 55 wandert, wie bereits erwähnt, das Segment der axial verlaufenden Nut 56 von der einen Seite zur anderen. Entweicht beim Rotationsvorgang ein Öldampfstrahl über die Düse 36 bzw. den Schlitz 58 oder die Öffnungen 59, dann wird auf einer vorbeilaufenden Folienbahn 50 ein Querstreifen oder auch anders verlaufende Streifen auf der Oberfläche der Folienbahn 50 kondensiert. Durch die Radialnuten mit Unterbrechungen werden dabei die Längsstreifen 61' mit ihren Unterbrechungen bzw. Öffnungen 63 kondensiert.

Dreht sich zum Beispiel die Walze 55 synchron zur Folienbahn 50, dann wird auf der Folie genau die Abwicklung der Nut 56 gemäß Figur 2 abgebildet.

Bei einem Durchmesser von 80 mm der Walze 55 und einer Bedampfungsbreite von 650 mm wird der Querstreifen mit einem Steigungswinkel von 21° gebildet. Der Abstand der Streifen beträgt dann ca. 250 mm (das entspricht dem Walzenumfang). Bei vier eingängigen Nuten 56 beträgt der Abstand ca. 63 mm.

Im Ausführungsbeispiel gemäß Figur 4 liegt eine Dichtlippe 64 gegen die Oberfläche der Walze 55 an. Die derartig geformte Dichtlippe 64 kann bei Aufspringen der Nut 56 einem größeren Verschleiß ausgesetzt sein. Deshalb ist es vorteilhaft, gemäß Figur 5 zahlreiche Öffnungen 59 dicht nebeneinander anzuordnen. In vorteilhafter Weise können die einzelnen Öffnungen 59 in zwei oder mehreren Reihen untereinander angeordnet sein, wobei die einzelnen Öffnungen 59 untereinander versetzt angeordnet sind, so daß ein durchgehender Streifen auf der Oberfläche der Folienbahn 50 abgebildet werden kann. Auf diese Weise wird verhindert, daß sich die Kante der Nut 56 verhakt.

Die Gleitdichtung 57 kann dann in einer gebogenen Bahn in Form einer Kaptonfolie oder Metallfolie gegen die Walze 55 zur Anlage gebracht werden (vergl. Figur 7). Die Folienbahn 50 kann entweder gleitend an der Düse 36 vorbei geführt werden oder mit geringem Abstand. Die Gleitdichtung 57 kann z. B. mittels einer Spannvorrichtung 65 gespannt werden. Die Folienbahn 50 bewegt sich gemäß Pfeil 68 an der Gleitdichtung 57 vorbei. Durch die gebogene Gleitdichtung gemäß Figur 3 und 7 wird die Dichtfläche vergrößert, außerdem dichtet nun nicht die Dichtlippe 64 gemäß Figur 4, sondern die ganze Dichtfläche gegenüber der Walze 55 ab.

### Bezugszeichenliste

- 1: Bandbeschichtungsanlage
- 2: Seitenteil
- 4: Seitenteil
- 7 bis 13: Umlenk-, Streck- und Spannrolle
- 18: Beschichtungswalze
- 19: Verdampfungsquelle
- 20: Aluminiumdrahtspule
- 21: Verdampfungsschiffchen
- 28: Beschichtungskammer
- 29: Wickeleinrichtung
- 34: Ölverdampfer
- 35: Aufwickelrolle
- 36: Düse
- 37: Abwickelrolle
- 43: Heizelement
- 47: Temperaturfühler
- 50: Folienbahn
- 55: zylindrische Walze
- 56: Nut
- 57: Gleitdichtung
- 58: Schlitz = Öffnung
- 59: Bohrung = Öffnung
- 60: Gehäuse
- 61,61': Streifen
- 62: Streifen
- 63: Unterbrechung bzw. Öffnung
- 64: Dichtlippe
- 65: Spannvorrichtung
- 67: Ölbad = Mittel
- 68: Pfeil

## Patentansprüche

1. Vorrichtung zum Herstellen von metallfreien Streifen auf im Vakuum beschichteten Folienbahnen (50) mit einem druckdicht verschließbaren Gehäuse, in dem eine Einrichtung (29) zur Aufnahme und Weiterbewegung einer Folienbahn (50), insbesondere für Kondensatoren, vorgesehen ist, sowie einer im Gehäuse vorgesehenen Verdampfungsquelle (19) und einer Düse (36) für den Austritt des zu verdampfenden Mittels (67) zur Verhinderung von Kondensation auf die vorbeilaufende Folienbahn (50), **dadurch gekennzeichnet, daß** vor dem Auslaß der Düse (36) mindestens eine eine Nut (56) aufweisende Walze (55) vorbei bewegbar ist und die Düse (36) aus mindestens einer sich in etwa über die gesamte Breite der Folienbahn (50) erstreckenden Öffnung (58, 59) gebildet ist.

2. Vorrichtung nach Anspruch 1, **dadurch gekennzeichnet, daß** sich die Nut (56) in etwa über die gesamte Breite der Walze (55) erstreckt, wobei die Nut (56) unterbrochen sein kann.

3. Vorrichtung nach Anspruch 1 oder 2, **dadurch gekennzeichnet, daß** die Nut (56) mit Bezug auf die Querebene der Walze (55) in einem Winkel zwischen 0° und 90° auf der Oberfläche der Walze (55) angeordnet ist.

4. Vorrichtung nach einem oder mehreren der vorhergehenden Ansprüche, **dadurch gekennzeichnet, daß** die Düse (36) zahlreiche nebeneinander angeordnete Auslaßöffnungen (59) aufweist und Parallel zur Längsachse der Walze (55) verläuft, wobei die Düse (36) in einer Blende bzw. Gleitdichtung (57) angeordnet ist.

5. Vorrichtung nach einem oder mehreren der vorhergehenden Ansprüche, **dadurch gekennzeichnet, daß** die Düse (36) aus einer Schlitzöffnung (58) gebildet ist, die sich in etwa über die gesamte Breite der Folienbahn (50) erstreckt.

6. Vorrichtung nach einem oder mehreren der vorhergehenden Ansprüche, **dadurch gekennzeichnet, daß** die Düse (36) Teil einer Gleitdichtung (57) ist, die gegen die rotierende Walze (55) dichtend anliegt und an der die Folienbahn (50) dichtend vorbei bewegt wird.

7. Vorrichtung nach einem oder mehreren der vorhergehenden Ansprüche, **dadurch gekennzeichnet, daß** in den längs verlaufenden Streifen (61) mit Abstand zueinander verlaufende Öffnungen (63) vorgesehen sind, wobei jeweils zwischen zwei quer verlaufenden Streifen (61, 62) mindestens eine Öffnung (63) vorgesehen ist.

8. Vorrichtung nach einem oder mehreren der vorhergehenden Ansprüche, **dadurch gekennzeichnet, daß** auf der Walze (55) eine oder mehrere sich radial erstreckende Nuten (56) vorgesehen sind, die eine oder mehrere Unterbrechungen aufweisen.

9. Vorrichtung nach einem oder mehreren der vorhergehenden Ansprüche, **dadurch gekennzeichnet, daß** die Walze (55) in Folienlängsrichtung und synchron zur Geschwindigkeit der Folienbahn (50) bewegbar ist.

10. Vorrichtung nach einem oder mehreren der vorhergehenden Ansprüche, **dadurch gekennzeichnet, daß** die Gleitdichtung (57) in einer gebogenen Bahn gegen die Walze (55) zur Anlage bringbar ist und mittels einer Spannvorrichtung (65) gespannt werden kann.

11. Vorrichtung nach einem oder mehreren der vorhergehenden Ansprüche, **dadurch gekennzeichnet, daß** die Folienbahn (50) gleitend an der Düse (36) anliegt oder mit Abstand zu dieser angeordnet ist.

12. Verfahren zum Herstellen von metallfreien Streifen auf im Vakuum beschichteten Folienbahnen (50) mit einem druckdicht verschließbaren Gehäuse, in dem eine Einrichtung (29) zur Aufnahme und Weiterbewegung einer Folienbahn (50), insbesondere für Kondensatoren, vorgesehen ist, sowie einer im Gehäuse vorgesehenen Verdampfungsquelle (19) und einer Düse (36) für den Austritt des zu verdampfenden Mittels (67) zur Verhinderung von Kondensation auf die vorbeilaufende Folienbahn (50), **dadurch gekennzeichnet, daß** auf der Oberfläche der Folienbahn (50) mittels der rotierenden Walze (55) und der Düse (36) quer ansteigende und/oder in Längsrichtung der Folienbahn (50) nicht metallisierende Streifen (61, 62) aufdampfbar sind.

## Claims

1. Apparatus for producing metal-free strips on foil webs (50) coated in a vacuum, comprising a housing (60) which can be pressure-tight closed and accomodates a device (29) for taking in and conveying a film web (50), particularly for capacitors, and further comprising an evaporating source (19) provided in the housing and a nozzle (36) for the outlet of the evaporating agent (67) to prevent a deposition on the passing foil web (50), **characterized in that** at least one drum (55) which has a groove (56) can be passed in front of the outlet of nozzle (36) and that the nozzle is formed by at least one opening (58, 59) extending approximately over the entire width of the foil web (50).

2. Apparatus in accordance with claim 1, **characterized in that** the groove (56) extends approximately over the entire width of drum (55) and that the groove (56) may be interrupted.

3. Apparatus in accordance with claims 1 or 2, **characterized in that** with respect to the transverse plane of drum (55), the groove (56) is provided on the surface of the drum (55) at an angle between 0° and 90°.

4. Apparatus in accordance with one or several of the aforesaid claims, **characterized in that** the nozzle (36) has a plurality of closely juxtaposed outlet openings (59), and that it runs parallel to the longitudinal axis of drum (55), the nozzle (36) being disposed in a diaphragm or a slide seal (57).

5. Apparatus in accordance with one or several of the aforesaid claims, **characterized in that** the nozzle (36) is formed by a slot opening (58) which extends approx. over the entire width of the foil web (50).

6. Apparatus in accordance with one or several of the aforesaid claims, **characterized in that** the nozzle (36) is part of a slide seal (57) which sealingly urges against the rotating drum (55) and in front of which the foil web (50) sealingly passes.

7. Apparatus in accordance with one or several of the aforesaid claims, **characterized in that** spaced apart openings (63) are provided in the longitudinally running strips (61), with at least one opening (63) being provided between two transversely running strips (61, 62).

8. Apparatus in accordance with one or several of the aforesaid claims, **characterized in that** one or several radially extending grooves (56), which have one or several interruptions, are provided on drum (55).

9. Apparatus in accordance with one or several of the aforedaid claims, **characterized in that** the drum (55) can be moved in the longitudinal direction of the foil and in synchrony with the speed of the foil web (50).

10. Apparatus in accordance with one or several of the aforesaid claims, **characterized in that** the slide seal (57), following a curved path, can be made to rest against the drum (55) and can be tightened by means of a tightening device (65).

11. Apparatus in accordance with one or several of the aforesaid claims, **characterized in that** the foil web (50) rests against the nozzle (36) in sliding contact or is spaced apart therefrom at a distance.

12. Process for the manufacture of metal-free strips on foil webs (50) coated in a vacuum, particularly for capacitors, employing a housing which can be pressure-tightly sealed and in which a device (29) is provided for taking-in and conveying a foil web (50), said housing further comprising an evaporator source (19) and a nozzle (36) for releasing the medium (67) to be evaporated onto the passing foil web (50) to prevent deposition on the said foil web (50), **characterized in that** by means of the rotating drum (55) and the nozzle (36) transversely ascending and/or longitudinal non-metallized strips (61, 62) can be applied to the foil web (50) by vapour deposition.

## Revendications

1. Dispositif pour l'obtention de bandes exemptes de métal sur des feuilles continues (50) enduites sous vide, comportant un boîtier étanche à la pression dans lequel est prévu un mécanisme (29) servant à la réception et au transport d'une feuille continue (50), notamment de feuille pour condensateurs, ainsi qu'une source de vaporisation (19) et une buse (36) pour la sortie de l'agent à vaporiser (67) évitant la condensation sur la feuille passante (50), **caractérisé en ce qu**'au moins un cylindre (55) présentant une rainure (56) peut être mû devant la sortie de la buse (36) et que la buse (36) comprend au moins une ouverture (58, 59) s'étendant à peu près sur toute la largeur de la feuille continue (50).

2. Dispositif selon la revendication 1, **caractérisé en ce que** la rainure (56) s'étend à peu près sur toute la largeur du cylindre (55), ladite rainure (56) pouvant être interrompue.

3. Dispositif selon la revendication 1 ou 2, **caractérisé en ce que** la rainure (56) prévue dans la surface du cylindre (55) forme un angle compris entre 0° et 90° par rapport au plan transversal du cylindre (55).

4. Dispositif selon l'une quelconque ou plusieurs des revendications précédentes, **caractérisé en ce que** la buse (36) présente de nombreuses ouvertures de sortie (59) adjacentes et qu'elle s'étend parallèlement à l'axe longitudinal du cylindre (55), ladite buse (36) étant disposée dans un diaphragme ou une garniture glissante (57).

5. Dispositif selon l'une quelconque ou plusieurs des revendications précédentes, **caractérisé en ce que** la buse (36) est en forme de fente (58) s'étendant à peu près sur toute la largeur de la feuille continue (50).

6. Dispositif selon l'une quelconque ou plusieurs des revendications précédentes, **caractérisé en ce que** la buse (36) fait partie d'une garniture glissante (57) qui s'applique de façon étanche contre le cylindre (55) en rotation et devant laquelle la feuille continue (50) passe en étant serrée contre celle-ci.

7. Dispositif selon l'une quelconque ou plusieurs des revendications précédentes, **caractérisé en ce que** des ouvertures (63) espacées les unes des autres sont prévues dans les bandes longitudinales (61), une ouverture (63) au moins étant prévue entre deux bandes transversales (61, 62).

8. Dispositif selon l'une quelconque ou plusieurs des revendications précédentes, **caractérisé en ce que** le cylindre (55) est muni d'une ou de plusieurs rainures radiales (56) présentant une ou plusieurs interruptions.

9. Dispositif selon l'une quelconque ou plusieurs des revendications précédentes, **caractérisé en ce que** le cylindre (55) peut être mû dans le sens longitudinal de la feuille et de façon synchrone à la vitesse de la feuille continue (50).

10. Dispositif selon l'une quelconque ou plusieurs des revendications précédentes, **caractérisé en ce que** la garniture glissante (57) peut être appliquée contre le cylindre (55) suivant une trajectoire courbée et qu'elle peut être serrée à l'aide d'un dispositif de serrage (65).

11. Dispositif selon l'une quelconque ou plusieurs des revendications précédentes, **caractérisé en ce que** la feuille continue (50) s'applique de façon glissante contre la buse (36) ou qu'elle passe devant celle-ce à une certaine distance.

12. Procédé pour l'obtention de bandes exemptes de métal sur des feuilles continues (50) enduites sous vide, comportant un boîtier étanche à la pression dans lequel est prévu un mécanisme servant à la réception et au transport d'une feuille continue (50), notamment de feuille pour condensateurs, ainsi qu'une source de vaporisation (19) prévue dans le boîtier et une buse (36) de sortie de l'agent à vaporiser (67) évitant la condensation sur la feuille passante (50), **caractérisé en ce que** des bandes non métallisées ascendantes transversalement et/ou s'étendant dans le sens longitudinal de la feuille continue (50) peuvent être appliquées par vaporisation sur la surface de la feuille continue (5) au moyen du cylindre rotatif (55) et de la buse (36).
